# EUROPÄISCHE PATENTSCHRIFT

(11) **EP 0 763 269 B1**
(45) Veröffentlichungstag und Bekanntmachung des Hinweises auf die Patenterteilung: **01.12.1999**
(21) Anmeldenummer: 95920802.6
(22) Anmeldetag: 05.05.1995
(51) Int. Cl.: H01R 23/70

(54) **OBERFLÄCHENMONTIERTER STECKVERBINDER**
SURFACE-MOUNTED PLUG-IN CONNECTOR
CONNECTEUR ENFICHABLE MONTE EN SURFACE

(30) Priorität: 31.05.1994 EP 94108392
(43) Veröffentlichungstag der Anmeldung: 19.03.1997
(73) Patentinhaber: SIEMENS AKTIENGESELLSCHAFT, 80333 München (DE)
(72) Erfinder: BORISCH, Wolfgang, D-93077 Bad Abbach-Peising (DE); BEUTHER, Christian, D-93049 Regensburg (DE); SCHREIB, Erich, D-80939 München (DE)
(86) Internationale Anmeldenummer: EP9501714
(87) Internationale Veröffentlichungsnummer: WO9533291

(56) Entgegenhaltungen:
- EP-A- 0 511 655
- DE-A- 4 016 890
- DE-U- 8 432 252
- US-A- 4 772 210

## Beschreibung

Die Erfindung betrifft einen auf einer Leiterplatte befestigten oberflächenmontierten Steckverbinder gemäß Oberbegriff des Patentanspruchs 1.

Es ist bekannt, Steckverbinder als SMD-Bauelemente (Surface Mounted Device) auf der Bauelementeseite einer Leiterplatte zu montieren (Der Elektroniker, Nr. 3/1986, S. 64 - 69). Die Steckverbinder sind zusätzlich zu den Lötstellen an ihren Anschlußkontakten mechanisch, beispielsweise mit Schrauben, Nieten o.ä. an der Leiterplatte befestigt. Durch solche Befestigungen wird jedoch das automatisierte Bestücken recht aufwendig.

Durch EP-A-0 511 655 ist ein auf einer Leiterplatte befestigter, oberflächenmontierter Steckverbinder mit einem Anschlußkontakte aufweisenden Leistenkörper bekannt, an dem mindestens ein um den Rand der Leiterplatte greifender Montagehaken vorgesehen ist und an dem mindestens ein Befestigungselement abragt, welches zur Befestigung des Steckverbinders auf der Leiterplatte in ein Loch der Leiterplatte eingeführt und eingerastet ist. Der Montagehaken des bekannten Steckverbinders ist elastisch und weist einen zur Leiterplatte parallelen ersten Abschnitt und einen hierzu senkrechten zweiten Abschnitt mit einem endseitigen Haken auf, wobei der zweite Abschnitt und in geringem Maße auch der erste Abschnitt des elastischen Montagehakens von der Stirnkante der Leiterplatte zurückfedern können.

Außerdem ist durch DE 40 16 890 Al eine Befestigsvorrichtung für die Sockel von Steckverbinderhälften, z. B. Federleisten oder Messerleisten auf Leiterplatten bekannt, bei welcher ein dornartiges Verbindungselement miteinander in Deckungslage befindliche Löcher in der Steckverbinderhälfte und in der Leiterplatte durchsetzt sowie dabei durch Widerlager auf voneinander abgewendete Flächen von Steckverbinderhälfte und Leiterplatte einwirkt. Hierbei besteht das dornartige Verbindungselement aus einer einendig mit einem Stützbund oder -kragen versehenen, radial geschlitzten Spreizhülse und einem in deren Zentralkanal axial eintreibbaren Spreizstift.

Der Erfindung liegt die Aufgabe zugrunde, einen oberflächenmontierten Steckverbinder zu schaffen, der einfach und schnell auf einer Leiterplatte befestigt werden kann.

Diese Aufgabe wird erfindungsgemäß durch die Merkmale des Patentanspruchs 1 gelöst.

Vorteilhafte Ausgestaltungen des Gegenstandes des Patentanspruchs 1 sind in den Unteransprüchen gekennzeichnet.

Zur Montage des Steckverbinders wird dieser bis zu einem Anschlag des Montagehakens über die Leiterplatte geschoben und anschließend mit einem Befestigungselement in ein Loch der Leiterplatte geschwenkt. Dabei rastet das Befestigungselement in das Loch ein.

Durch die Ausgestaltung des Befestigungselements und des Montagehakens hat die erfindungsgemäße Lösung den Vorteil, daß die Anschlußkontakte des Steckverbinders während der Montage nicht die Lotpaste verwischen. Durch die Befestigung mit Hilfe des Befestigungselements werden die Lötstellen vorteilhafterweise mechanisch nicht belastet.

Durch Gleitschrägen des Montagehakens wird die Montage erleichtert. Weniger Montageschritte werden benötigt, wenn der Montagehaken und das Befestigungselement einstückig zusammen mit dem Leistenkörper hergestellt sind.

Zwei Ausführungsbeispiele der Erfindung sind im folgenden unter Bezugnahme auf die schematischen Zeichnungen näher erläutert. Es zeigen:
- Figur 1:: eine perspektivische Ansicht eines erfindungsgemäßen Steckverbinders,
- Figur 2:: eine Seitenansicht des Steckverbinders nach Figur 1,
- Figur 3:: eine Seitenansicht während der Montage des Steckverbinders,
- Figur 4:: eine Seitenansicht eines weiteren erfindungsgemäßen Steckverbinders zu Beginn der Montage auf eine Leiterplatte,
- Figur 5:: einen Schnitt durch den Steckverbinder gemäß Figur 4 im montierten Zustand und
- Figur 6:: eine vergrößerte Teilansicht des Steckverbinders gemäß Figur 5.

In Steuergeräten für Kraftfahrzeuge werden vermehrt oberflächenmontierte Bauelemente (SMD) eingesetzt. Diese sparen Platz und sind automatisiert zu bestücken. In gleicher Weise sollen Steckverbinder als oberflächenmontierte Bauelemente verwendet werden.

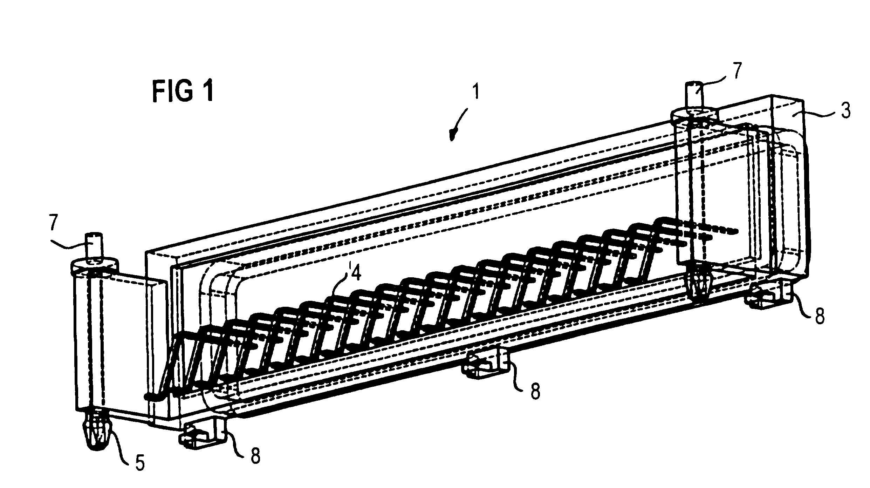

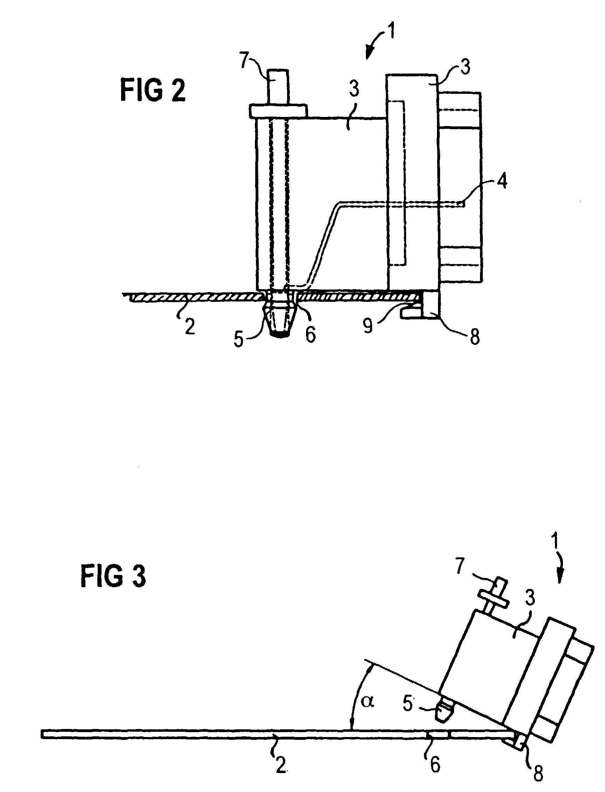

Die Figur 1 zeigt einen erfindungsgemäßen oberflächenmontierbaren Steckverbinder 1, beispielsweise eine Messerleiste, die auf einer Leiterplatte 2 (Figur 2) befestigt werden soll. Der Steckverbinder 1 weist einen Leistenkörper 3 auf, durch den elektrische Anschlußkontakte 4 hindurchführen, die einerseits auf der Leiterplatte 2 angelötet und andererseits mit einem nicht dargestellten Gegenstecker und einem Anschlußkabel verbunden werden.

Die Anschlußkontakte 4 sind leiterplattenseitig zweifach abgewinkelt, wobei die Enden der Anschlußkontakte 4 in etwa parallel zu der Leiterplattenebene gebogen sind. Diese Enden werden später auf die Leiterplatte 2 gelötet.

Der Steckverbinder 1 weist mindestens zwei Befestigungselemente 5 auf, die aus dem Leistenkörper 3 nach unten - zur Leiterplatte 2 hin - herausragen und die in Löcher 6 der Leiterplatte eingerastet sind. Die Befestigungselemente 5 sind hier als Spreizdübel einstückig mit dem Leistenkörper 3 ausgebildet. Hierzu sind die Befestigungselemente 5 ringförmig mit konvexen Rastnase ausgebildet und in axialer Richtung geschlitzt, damit sie sich auseinanderspreizen können. Die Befestigungselemente 5 sind koaxial zu Bohrungen des Leistenkörpers 3 angeordnet.

Mit Hilfe eines Fixier- oder Spreizstifts 7, der von außen zugeführt, durch die Bohrung des Leistenkörpers 3 gesteckt und in das Befestigungselement 5 eingepreßt wird, wird der Steckverbinder 1 an der Leiterplatte 2 befestigt.

Des weiteren weist der Leistenkörper 3 Montagehaken 8 auf, die ebenfalls auf der Unterseite des Steckverbinders 1 angeordnet sind. Die Montagehaken 8 weisen Einführschrägen 9 auf, durch die die Montage des Steckverbinders 1 erleichtert wird.

Zu Beginn der Montage des Steckverbinders 1 (Figur 3) wird die Leiterplatte 2 entlang der Einführschräge 9 bis zum Anschlag in die Montagehaken 8 eingeschoben. Der Steckverbinder 1 muß hierzu um einen Winkel α von etwa 25° zur Leiterplatte 2 gekippt werden. Der Winkel α ist abhängig von der Höhe des Befestigungselements 5, dem Durchmesser der Löcher 6 in der Leiterplatte 2 und der Ausgestaltung des Montagehakens 8 mit seiner Einführschräge 9.

Anschließend wird der Steckverbinder 1 gegen die Leiterplatte 2 derart geschwenkt, daß die Befestigungselemente 5 durch die entsprechenden Löcher 6 der Leiterplatte 2 gesteckt werden und dort einrasten. Durch das Einführen der Befestigungselemente 5 in die Löcher 6 wird der Steckverbinder in seiner Lage positioniert. Um das Einrasten in die Löcher 6 zu erleichtern, weisen die Befestigungselemente 5 Montageschrägen 10 auf, d.h. sie sind leicht angespitzt.

Da die Befestigungselemente 5 als Rasthaken ausgebildet sind, muß eine gewisse Kraft überwunden werden, um die Befestigungselemente 5 in die Löcher 6 zu drücken. Hierbei dienen die Montagehaken 8 als Kraftgegenlager. Gleichzeitig dienen sie auch als Führung beim Schwenken gegen die Leiterplatte 2.

Nachdem die Befestigungselemente 5 mit Hilfe der Fixierstifte 7 verspreizt sind, können die Anschlußkontakte 4 zusammen mit den restlichen Bauelementen der Leiterplatte 2 gelötet werden. Da der Steckverbinder 1 bereits vor dem Lötvorgang an der Leiterplatte 2 befestigt ist, werden die Lötstellen der Anschlußkontakte 4 mechanisch entlastet.

Bei der Montage des Steckverbinders 1 wird Lotpaste, die auf Lötflecken der Leiterplatte 2 aufgebracht ist, um die Anschlußkontakte 4 zu löten, nicht durch die Anschlußkontakte 4 verwischt oder auch nicht teilweise abgetragen, da sich die Anschlußkontakte 4 erst in ihrer Endposition von oben auf die Leiterplatte 2 senken.

Die Anschlußkontakte 4 liegen plan auf der Leiterplatte 2 auf, wenn die Befestigungselemente 5 in den Löchern 6 der Leiterplatte 2 eingerastet sind.

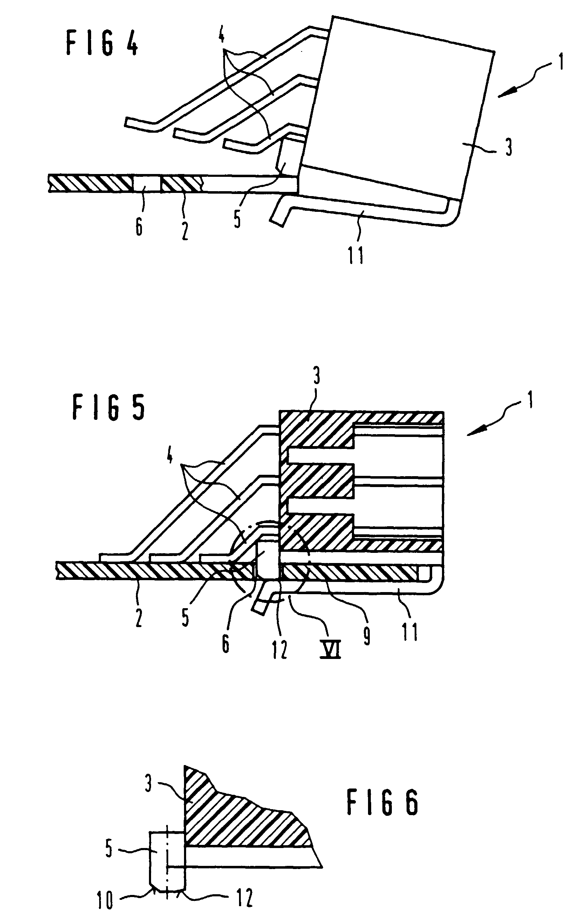

Ein weiteres Ausführungsbeispiel eines erfindungsgemäßen Steckverbinders 1 ist in den Figuren 4 bis 6 dargestellt. Elemente gleicher Konstruktion oder Funktion tragen dabei dieselben Bezugszeichen wie in den Figuren 1 bis 3.

Der Montagehaken 8 ist bei diesem Steckverbinder 1 federnd ausgebildet und wird im folgenden als Halteclip 11 bezeichnet. Zu Beginn der Montage des Steckverbinders 1 (Figur 4) wird der Halteclip 11 von dem Leistenkörper 3 weggebogen, d.h. der Halteclip 11 wird auseinandergespreizt, und das Befestigungselement 5 auf die Leiterplatte 2 aufgesetzt. Dadurch kann der Steckverbinder 1 auf die Leiterplatte 2 in seine Position, in der er gelötet werden soll, geschoben werden. Dabei wird der Rand der Leiterplatte 2 zwischen den Halteclip 11 und den Leistenkörper 3 eingeführt.

Das Befestigungselement 5 ragt aus dem Leistenkörper 3 heraus. Dadurch gleitet das Befestigungselement 5 während der Montage auf der Leiterplatte 2 entlang. Da hier nur zwei Befestigungselemente 5 vorhanden und diese am Rande des Steckverbinders 1 angeordnet sind, und zwar dort, wo keine Anschlußkontakte 4 ausgebildet sind, wird die Lotpaste bei der Montage durch die Befestigungselemente 5 nicht verwischt.

Die Enden der Anschlußkontakte 4 werden durch die Befestigungselemente 5 von der Leiterplatte 2 ferngehalten, da der Steckverbinder 1 nur - wie in Figur 4 dargestellt - gekippt zu montieren ist.

Um die Montage zu erleichtern und die Leiterplatte 2 nicht zu beschädigen, weisen die Befestigungselemente 5 jeweils eine Gleitschräge 12 (Figur 6) auf, die während des Einschiebens des Steckverbinders 1 auf der Leiterplatte 2 entlang gleitet. Die Gleitschräge hat einen Winkel von etwa 5 bis 10°.

Der Halteclip 11 weist ein abgewinkeltes Ende auf, mit dem das Auseinanderspreizen, das Einfädeln und das Einführen des Steckverbinders 1 ebenfalls erleichtert wird.

Die Befestigungselemente 5 rasten in die Löcher 6 der Leiterplatte 2 ein, sobald der Steckverbinder 1 seine Endposition erreicht hat. Dabei senken sich die Anschlußkontakte 4 auf nicht dargestellten Lötflächen der Leiterplatte 2 ab. Der Leistenkörper 3 liegt dann auf der Leiterplatte 2 auf und die Enden der Anschlußkontakte 4 tauchen in Lotpaste, die auf die Lötflächen aufgetragen ist, ein.

Die Löcher 6 befestigen den Steckverbinder 1 derart, daß er in Richtung der Leiterplattenebene nur wenig Bewegungstoleranz hat. Hierzu darf der Durchmesser des Befestigungselements 5 nicht viel kleiner sein als der Durchmesser eines Lochs 6. In Richtung senkrecht zur Leiterplatte 2 wird der Steckverbinder 1 durch den Halteclip 11 gehalten, so daß das Befestigungselement 5 nicht aus dem Loch herausfallen kann. Infolgedessen ist der Steckverbinder 1 an der Leiterplatte 2 vorläufig befestigt.

In der Lötposition können die Anschlußkontakte 4 zusammen mit den restlichen SMD-Bauelementen der Leiterplatte 2 in einem Arbeitsgang gelötet werden, wodurch der Steckverbinder 1 zusätzlich an der Leiterplatte 2 mechanisch befestigt wird. Durch die vorläufige Befestigung mit den Befestigungselementen 5 und den Halteclips 11 bleiben die Lötstellen mechanisch spannungsfrei.

Der Halteclip 11 ist mit seinem Schenkel so ausgestaltet, daß die Leiterplatte 2 nicht vollständig in den Halteclip 11 eingeschoben werden kann. Auf diese Weise kann der Schenkel des Halteclips 11 noch eine Kraft auf die Leiterplatte 2 ausüben und diese zwischen sich und dem Leistenkörper 3 einklemmen. Dies wird dadurch bewerkstelligt, daß der Schenkel des Halteclips 11 nicht ganz parallel zu dem Leistenkörper 3 ausgebildet ist, sondern eine Einführschräge 9 von etwa 5° aufweist, d.h. der Schenkel führt leicht von dem Leistenkörper 3 weg. Außerdem ist der engste Abstand des Schenkels geringer als die Dicke der Leiterplatte 2. Infolgedessen dient der Halteclip 11 auch als Anschlag für die Leiterplatte 2.

Das Ende jedes Befestigungselements 5 weist zusätzlich zu der Gleitschräge 12 eine Montageschräge 10 auf, durch die das Einrasten des Befestigungselements 5 in das Loch 6 erleichtert wird.

Es ist vorteilhaft, die Befestigungselemente 5 und die Löcher 6 rund auszubilden. Damit wird ein Verkanten beim Einrasten weitgehend vermieden und der Steckverbinder 1 kann mit einer recht kleinen Toleranz in seiner Lage positioniert werden. Somit wird sichergestellt, daß die Anschlußkontakte 4 genau auf den Lötflächen der Leiterplatte 2 liegen und keinen Kurzschluß zu anderen Leiterbahnen auf der Leiterplatte 2 verursachen.

Der Leistenkörper 3 ist zusammen mit den Befestigungselementen 5 und den Halteclips 11 oder Montagehaken 8 einstückig, beispielsweise durch Spritzgießen, aus Isolierstoffmaterial, z.B. aus Kunststoff, hergestellt.

Die Anzahl der Befestigungselemente 5 und der Montagehaken 8 ist unwesentlich für die Erfindung. Als recht günstig haben sich zwei Befestigungselemente 5 und zwei Montagehaken 8 erwiesen.

## Patentansprüche

1. Auf einer Leiterplatte (2) befestigter, oberflächenmontierter Steckverbinder (1) mit einem Anschlußkontakte (4) aufweisenden Leistenkörper (3), an dem mindestens ein um den Rand der Leiterplatte (2) greifender Montagehaken (8 bzw. 11) vorgesehen ist und an dem mindestens ein Befestigungselement (5) abraqt, welches zur Befestigung des Steckverbinders (1) auf der Leiterplatte (2) in ein Loch (6) der Leiterplatte (2) eingeführt und eingerastet ist,
**dadurch gekennzeichnet,**
daß der Montagehaken (8 bzw. 11) beim Aufschieben des Steckverbinders (1) auf die Leiterplatte (2) als Anschlag dient, um den der Steckverbinder (1) bei der Montage geschwenkt wird.

2. Steckverbinder nach Anspruch 1,
**dadurch gekennzeichnet,**
daß der Montagehaken (8 bzw. 11) eine Einführschräge (9) aufweist.

3. Steckverbinder nach Anspruch 1 oder 2,
**dadurch gekennzeichnet,**
daß der Montagehaken als federnder Halteclip (11) ausgebildet ist, der von dem Steckverbinder (1) abspreizbar ist und den Steckverbinder (1) an der Leiterplatte (2) vorläufig befestigt.

4. Steckverbinder nach Anspruch 3,
**dadurch gekennzeichnet,**
daß der Halteclip (11) ein abgewinkeltes Ende aufweist.

5. Steckverbinder nach einem der Ansprüche 3 oder 4,
**dadurch gekennzeichnet,**
daß der Halteclip (11) einen Schenkel aufweist, der von dem Leistenkörper (3) wegführt, so daß eine Einführschräge (9) von etwa 5° gebildet ist.

6. Steckverbinder nach einem der Ansprüche 3 bis 5,
**dadurch gekennzeichnet,**
daß der engste Abstand des Schenkels des Halteclips (11) geringer als die Dicke der Leiterplatte (2) ist.

7. Steckverbinder nach einem der Ansprüche 1 bis 6,
**dadurch gekennzeichnet,**
daß das Befestigungselement (5) mit Hilfe eines Spreizstiftes (7), der durch eine Bohrung des Leistenkörpers (3) geführt ist, in dem Loch (6) der Leiterplatte (2) verspreizt ist.

8. Steckverbinder nach einem der Ansprüche 1 bis 6,
**dadurch gekennzeichnet,**
daß das Befestigungselement (5) als Rasthaken ausgebildet ist, der einstückig mit dem Leistenkörper (3) hergestellt ist.

9. Steckverbinder nach einem der vorgehenden Ansprüche,
**dadurch gekennzeichnet,**
daß der Leistenkörper (3), das Befestigungselement (5) und der Montagehaken (8 bzw. 11) einstückig aus Isolierstoffmaterial hergestellt sind.

## Claims

1. Surface-mounted plug-in connector (1) fastened on a printed circuit board (2), with a connector-strip body (3) having connection contacts (4), on which at least one mounting hook (8 and/or 11) is provided, the said mounting hook reaching around the edge of the printed circuit board (2), and from which at least one fastening element (5) projects, which is inserted into a hole (6) in the printed circuit board (2) and latched into place for the purpose of fastening the plug-in connector (1) on the printed circuit board (2),
characterized
in that the mounting hook (8 and/or 11) serves as a stop when the plug-in connector (1) is pushed onto the printed circuit board (2), about which stop the plug-in connector (1) is pivoted in the course of mounting.

2. Plug-in connector according to Claim 1,
characterized
in that the mounting hook (8 and/or 11) has a lead-in bevel (9).

3. Plug-in connector according to Claim 1 or 2,
characterized
in that
the mounting hook is designed as a resilient holding clip (11), which can be spread away from the plug-in connector (1) and provisionally fastens the plug-in connector (1) to the printed circuit board (2).

4. Plug-in connector according to Claim 3,
characterized
in that the holding clip (11) has an angular end.

5. Plug-in connector according to either of Claims 3 and 4,
characterized
in that the holding clip (11) has a limb leading away from the connector-strip body (3), a lead-in bevel (9) of approximately 5° thereby being formed.

6. Plug-in connector according to one of Claims 3 to 5,
characterized
in that the narrowest spacing of the limb of the holding clip (11) is smaller than the thickness of the printed circuit board (2).

7. Plug-in connector according to one of Claims 1 to 6,
characterized
in that the fastening element (5) is braced in the hole (6) in the printed circuit board (2) with the aid of an expanding pin (7), which is led through a hole in the connector-strip body (3).

8. Plug-in connector according to one of Claims 1 to 6,
characterized
in that the fastening element (5) is designed as a latching hook produced in one piece with the connector-strip body (3).

9. Plug-in connector according to one of the preceding claims,
characterized
in that the connector-strip body (3), the fastening element (5) and the mounting hook (8 and/or 11) are produced in one piece from insulating material.

## Revendications

1. Connecteur enfichable (1) monté en surface fixé sur un circuit imprimé (2), comprenant un corps de barette (3) pourvu de contacts de raccordement (4) sur lequel on prévoit au moins un crochet de montage (8 resp. 11) enserrant le bord du circuit imprimé (2) et sur lequel s'élève au moins un élément de fixation (5) qui est introduit et enclenché dans un trou (6) du circuit imprimé (2) afin de fixer le connecteur enfichable (1) sur le circuit imprimé (2), caractérisé en ce que le crochet de montage (8 resp. 11) sert de butée, lorsqu'on pousse le connecteur enfichable (1) sur le circuit imprimé (2), butée autour de laquelle on fait pivoter le connecteur enfichable (1) lors du montage.

2. Connecteur enfichable selon la revendication 1, caractérisé en ce que le crochet de montage (8 resp. 11) est pourvu d'une surface inclinée d'introduction (9).

3. Connecteur enfichable selon l'une des revendications 1 ou 2, caractérisé en ce que le crochet de montage est exécuté en tant que clip de maintien (11) élastique qui peut être écarté du connecteur enfichable (1) et fixe le connecteur enfichable (1) sur le circuit imprimé (2) de manière provisoire.

4. Connecteur enfichable selon la revendication 3, caractérisé en ce que le clip de maintien (11) est pourvu d'une extrémité pliée.

5. Connecteur enfichable selon l'une des revendications 3 ou 4, caractérisé en ce que le clip de maintien (11) possède une branche qui s'éloigne du corps de barette (3) de manière à former une surface inclinée d'introduction (9) d'environ 5°.

6. Connecteur enfichable selon l'une des revendications 3 à 5, caractérisé en ce que l'écartement le plus étroit de la branche du clip de maintien (11) est inférieur à l'épaisseur du circuit imprimé (2).

7. Connecteur enfichable selon l'une des revendications 1 à 6, caractérisé en ce que l'élément de fixation (5) est écarté dans le trou (6) du circuit imprimé (2) à l'aide d'une broche d'écartement (7) que l'on fait passer à travers un alésage du corps de barette (3).

8. Connecteur enfichable selon l'une des revendications 1 à 6, caractérisé en ce que l'élément de fixation (5) est exécuté en tant que crochet à crans solidaire du corps de barette (3).

9. Connecteur enfichable selon l'une des revendications précédentes, caractérisé en ce que le corps de barette (3), l'élément de fixation (5) et le crochet de montage (8 resp. 11) sont fabriqués d'un seul morceau dans un matériau isolant.
